# EUROPEAN PATENT APPLICATION

(11) **EP 0 671 760 A2**
(43) Date of publication of application: **13.09.1995**
(21) Application number: 95301417.2
(22) Date of filing: 06.03.1995
(51) Int. Cl.: H01L 21/265

(54) **A method of fabricating a semiconductor device using high dose implantation**

(30) Priority: 07.03.1994 JP 35509/94
(71) Applicant: Oki Electric Industry Co., Ltd., Tokyo (JP)
(72) Inventor: Okihara, Masao, c/o Oki Electric Industry Co. Ltd., Tokyo (JP); Hirashita, Norio, c/o Oki Electric Ind. Co. Ltd., Tokyo (JP)
(74) Representative: Boydell, John Christopher

(57) **Abstract**

A method of fabricating a semiconductor device, comprising the steps of : forming a mask layer (4) on a silicon substrate (1) so that an inclination angle of a surface of the mask layer with respect to a surface of the silicon substrate does not exceed 54.7 degrees ; implanting dopants at a high dose in the silicon substrate (1) using the mask layer (4) so that the surface of the silicon substrate is transformed into an amorphous layer (6), the amorphous layer (6) having no inclination angle exceeding 54.7 degrees with respect to the surface of the silicon substrate ; and annealing the silicon substrate having the amorphous layer so that the amorphous layer grows into a high-dose dopant diffusion layer (7).

## Description

The present invention relates to a method of fabricating a semiconductor device, and more particularly, to a method of eliminating crystal defects occurring in the region of high-dose dopant diffusion layers.

This technology is typified by, for example, the following references:
1. J. Appl. Phys., 65[7], 1989-3, M. Horiuchi, M.
Tamura and S. Aoki, "Three-dimensional solid- phase-epitaxial regrowth from As+⁻implanted Si", P. 2238-2242.
2. J. Appl. Phys., 66[10], 1989-11. H. Cerva and K. H. Kusters, "Defect formation in silicon at a mask edge during crystallization of an amorphous implantation layer", P. 4723-4728.
3. Journal of Crystal Growth 99,1990, M. Tamura and M. Horiuchi, "Two-Dimensional Solid Phase Epitaxial Recovery of Amorphous Si Formed by Ion Implantation", P. 245-253.
4. J. Electrochem. Soc., 140, 1993-3, H. Cerva and W. Bergholz, "Implantation Defects Below Mask Edges in Silicon", P. 780-786.

Conventionally, ion implantation has mainly been used as a method of forming a dopant diffusion layer in a silicon substrate in the fabrication of semiconductor devices. However, as described in the aforesaid references 1 - 4, crystal defects are produced at the interface between the amorphous layer formed by high dose ion implantation and the silicon crystals. It is known that if these defects extend into the silicon substrate from the diffusion layer region, they have fatal effects on the properties of the device, e.g. increased leakage current, decrease of charge retention time or higher power consumption. Hereinbelow, this phenomenon will be described taking a metal oxide semiconductor field effect transistor (MOSFET) as an example.

First, a field oxide film is formed by selective oxidation process on a silicon substrate (local oxidation of silicon, i.e., LOCOS process), a gate oxide film is formed by gate oxidation, and polysilicon is formed which acts as a gate electrode. Low dose phosphorus ion implantation is carried out using the gate electrode as a mask, and annealing is performed in a non-oxidizing atmosphere so as to form a low-dose diffusion layer. Subsequently, a silicon oxide film is deposited over the entire surface, and side walls are formed at the sides of the gate electrode by anisotropic etching. After forming a thin silicon oxide film by thermal oxidation, high dose arsenic ion implantation is performed so as to reduce diffusion resistance using the side walls as a mask. For example, a uniform amorphous layer is formed on the surface of the silicon substrate by ion implantation of arsenic at a dose of 1 x 10¹⁵ [cm-²] or more at room temperature. The amorphous layer is changed into a source/drain region of a high-dose diffusion layer N⁺ by annealing process in a non-oxidizing atmosphere.

However, according to the conventional method of manufacturing a semiconductor device, crystal lattice defects occur at the interface between the amorphous layer and the silicon substrate, and in particular, at the edges of the side walls, during the annealing process used to form the source/drain region.

As these defects function as trap sites of heavy metals, etc., current tends to leak through the defects if the defects extend from the diffusion layer region into the interior of the silicone substrate. This leads to decrease of charge retention time, higher power consumption and, in extreme cases, loss of yield.

The mechanism whereby these defects occur will now be described. An amorphous layer is formed in the silicon substrate by implanting dopants at high dosage. Subsequently, when annealing is carried out in a non-oxidizing atmosphere, these dopants are activated and recrystallization of the amorphous layer takes place. The amorphous layer grows epitaxially on the crystalline structure of the silicon substrate, however epitaxial growth on the side wall edges proceeds more rapidly in the [100] or [110] direction than in the [111] direction. A notch therefore forms along the [111] direction on the side wall edges, and this remains as crystal lattice defects in the end product. In other words, crystal lattice defects on the side wall edges are formed due to the fact that the rate of recrystallization in the [111] ] direction is very much slower than in other directions.

Further, when the side wall edges of the gate electrode formed in the upper part of the field oxide film are situated in an active region of the device, the crystal lattice defects formed at the side wall edges grow into dislocations due to induced stress in the field oxide film during the subsequent annealing process.

It is an object of the present invention to provide a method of fabricating a semiconductor device by which the occurrence of crystal lattice defects in the silicon substrate is prevented.

According to one aspect of the present invention, a method of fabricating a semiconductor device, comprises the steps of: forming a mask layer on a surface of a silicon substrate so that an inclination angle of a surface of the mask layer with respect to the surface of the silicon substrate does not exceed 54.7 degrees; implanting dopants at a high dose in the silicon substrate using the mask layer so that the surface of the silicon substrate is transformed into an amorphous layer, the amorphous layer having no inclination angle exceeding 54.7 degrees with respect to the surface of the silicon substrate; and annealing the silicon substrate having the amorphous layer so that the amorphous layer grows into a high-dose dopant diffusion layer.

According to another aspect of the present invention, a method of fabricating a semiconductor device, comprises the steps of: forming a mask layer on a surface of a silicon substrate; forming a silicon oxide film on the surface of the silicon substrate 1 by thermal oxidation; implanting dopants at a dose of not more than 1 x 10¹⁵ [cm-²] so that the surface of the silicon substrate is transformed into an amorphous layer; and annealing the silicon substrate having the amorphous layer so that the amorphous layer grows into a high-dose dopant diffusion layer.

According to still another aspect of the invention, a method of fabricating a semiconductor device, comprises the steps of: forming a mask layer on a surface of a silicon substrate; forming a silicon oxide film on a surface of the silicon substrate 1 by thermal oxidation; heating the silicon substrate at a temperature of 300°C - 400°C, and then implanting dopants at a high dose so that the surface of the silicon substrate is transformed into an amorphous layer; and annealing the silicon substrate having the amorphous layer so that the amorphous layer grows into a high-dose dopant diffusion layer.

According to a further aspect of the present invention, a method of fabricating a semiconductor device, comprises the steps of: forming a mask layer on a surface of a silicon substrate; forming a silicon oxide film on a surface of the silicon substrate 1 by thermal oxidation; implanting dopants at a high dose obliquely so that the surface of the silicon substrate is transformed into an amorphous layer, the amorphous layer having no inclination angle exceeding 54.7 degrees with respect to the surface of the silicon substrate; and annealing the silicon substrate having the amorphous layer so that the amorphous layer grows into a high-dose dopant diffusion layer.

According to a still further aspect of the present invention, a method of fabricating a semiconductor device, comprises the steps of: forming a mask layer on a surface of a silicon substrate; implanting dopants at a low dose below 1 x 10-¹⁴ [cm-9; annealing the silicon substrate in non-oxidation atmosphere, thereby making a low-dose dopant diffusion layer; forming side wall at a side of the gate electrode; depositing an insulating layer including a dopant at a high dose above 1 x 10-¹⁵ [cm-²]; and annealing the silicon substrate and the insulating layer at a temperature of about 800°C so that the dopant of the insulating layer diffuse into the silicon substrate and the low-dose dopant diffusion layer grows into a high-dose dopant diffusion layer.

### BRIEF DESCRIPTION OF THE DRAWINGS

Figs. 1A-1C show the process for manufacturing a semiconductor device according to a first embodiment of this invention.
Figs. 2A-2C show the process for manufacturing a semiconductor device according to a second embodiment of this invention.
Figs. 3A-3D show the process for manufacturing a semiconductor device according to a third embodiment of this invention.
Figs. 4A-4C show the process for manufacturing a semiconductor device according to a fourth embodiment of this invention.
Figs. 5A-5C show the process for manufacturing a semiconductor device according to a fifth embodiment of this invention.
Figs. 6A-6C show the process for manufacturing a semiconductor device according to a sixth embodiment of this invention.
Figs. 7A-7C show the process for manufacturing a semiconductor device according to a seventh embodiment of this invention.
Figs. 8A-8C show the process for manufacturing a semiconductor device according to an eighth embodiment of this invention.
Figs. 9A-9D show the process for manufacturing a semiconductor device according to a ninth embodiment of this invention.
Figs. 10A-1 OC show the process for manufacturing a semiconductor device according to a tenth embodiment of this invention.
Figs. 11A-11C show the process for manufacturing a semiconductor device according to an eleventh embodiment of this invention.
Figs. 12A-12C show the process for manufacturing a semiconductor device according to a twelfth embodiment of this invention.
Figs. 13A-13C show the process for manufacturing a semiconductor device according to a thirteenth embodiment of this invention.
Figs. 14A-14C show the process for manufacturing a semiconductor device according to a fourteenth embodiment of this invention.

Preferred embodiments of the present invention will be described with reference to the drawings.

### First Embodiment

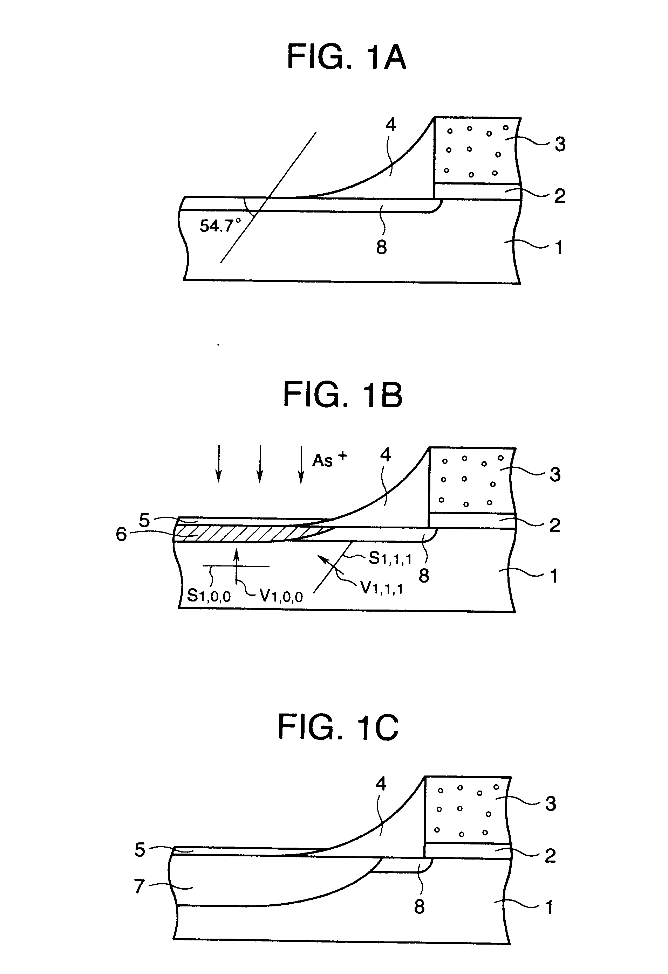

Figs. 1A-1 C show the process for manufacturing a semiconductor device according to a first embodiment of this invention. According to this manufacturing process, a mask material (e.g. side walls 4 in a lightly doped drain (LDD) structure) to act as a mask when high dose ion implantation of dopants is performed, is formed such that its inclination with respect to, for example, the surface of an (100) silicon substrate 1 does not exceed 54.7 degrees, which is the angle between a (111) plane (shown as S₁,₁,₁ in the figures) corresponding to the [111] direction (shown as V₁,₁,₁ in the figures) and the surface of the (100) silicon substrate 1. The manufacturing process will be described with reference to Figs. 1A-1C.

For example, a field oxide film is formed on the surface of the (100) silicon substrate 1 by the LOCOS process or a similar method, gate oxidation is performed so as to form a gate oxide film 2, and polysilicon is formed to act as a gate electrode 3. Phosphorus is then ion implanted into the silicon substrate at low dose using the gate electrode 3 as a mask, and a low-dose diffusion layer 8 is formed by annealing in a non-oxidizing atmosphere. Subsequently, a silicon oxide film is deposited over the entire surface, and side walls 4 as shown in Fig. 1 are formed on the lateral faces of the gate electrode 3 by anisotropic etching. In this process, the inclination, with respect to the surface of the (100) silicon substrate 1, of the side walls 4 which function as a mask during subsequent ion implantation of dopants, is arranged not to exceed 54.7 degrees.

Next, after forming a silicon oxide film 5 of approximately 20 [nm] on the surface of the silicon substrate 1 by thermal oxidation process as shown in Fig. 1 B, a dopant such as arsenic is ion implanted at a high dose (above 1 x 10¹⁵ [cm-²]). Due to the damage caused by ion implantation, an amorphous layer 6 is formed on the surface of the silicon substrate 1. As the shape of this amorphous layer 6 depends on that of the side walls 4, a plane oriented at 54.7 degrees to the surface of the silicon substrate 1 does not appear in the amorphous layer 6.

Annealing is performed in a non-oxidizing atmosphere which activates the dopants and causes recrystallization of the amorphous layer 6. As a (111) plane S₁,₁,₁ corresponding to the [111] direction Vq,₁,₁ does not appear in the amorphous layer 6, epitaxial growth preferentially occurs in the [100] direction V₁,ₒ,ₒ, and a high-dose dopant diffusion layer 7 without crystal lattice defects as shown in Fig. 1 C, is formed.

As described hereinbefore, according to the first embodiment, the mask material used in high dose ion implantation is formed such that its inclination with respect to the surface of the silicon substrate 1 does not exceed 54.7 degrees. The high-dose dopant diffusion layer 7 is thereby formed free from crystal lattice defects when the amorphous layer 6 due to high dose ion implantation of dopants is recrystallized. This permits reduction of leakage current, increase of charge retention time and decrease of power consumption in semiconductors (referred to hereinafter as suppression of semiconductor characteristic deterioration), and prevents decline of yield.

### Second Embodiment

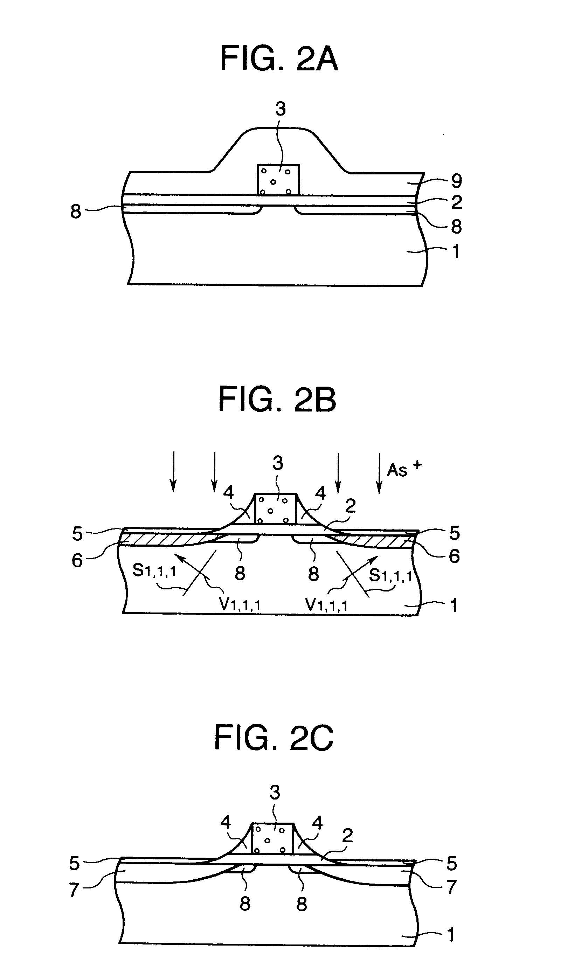

Figs. 2A-2C show the process of manufacturing a semiconductor device according to a second em- bodimentof this invention. This process will be described with reference to Figs. 2A-2C.

Gate oxidation is performed by thermal oxidation so as to form a gate oxide film 2 on a surface of a silicon substrate 1 in the same way as normally used to manufacture a MOSFET, and then polysilicon to form a gate electrode 3 is deposited by chemical vapor deposition (referred to hereinafter as CVD). After photolithography, anisotropic etching is performed so as to pattern the aforesaid polysilicon and form the gate electrode 3 shown in Fig. 2A. Using this gate electrode 3 as a mask, a dopant such as phosphorus is ion implanted at low dose (below 1 x 1014 [cm-²]). Annealing is performed in a non-oxidizing atmosphere to form a low-dose dopant diffusion layer 8, and an insulating film 9 of silicon oxide or the like is thickly deposited over the whole surface.

The deposited insulating film 9 is then subjected to isotropic etching by wet etching its whole surface with a solution of fluoric acid or ammonium fluoride or the like of several percent concentration so as to form smooth side walls 4 on the surface of the silicon substrate 1. It is arranged that, when performing isotropic etching of the insulating film 9 to form these side walls 4, the angle between the surface of the side walls 4 and the surface of the silicon substrate 1 does not exceed 54.7 degrees. This can be achieved by adjusting the concentration, etc., of the etching solution such as fluoric acid or ammonium fluoride. After forming a silicon oxide film 5 of approximately 20 [nm] on the surface of the silicon substrate 1, high dose ion implantation (above 1 x 10¹⁵ [cm-9) of a dopant such as arsenic is performed. Due to the damage caused by ion implantation, an amorphous layer 6 is formed on the surface of the silicon substrate 1, but due to the shape of the side walls 4, a plane S_{1,1,1} inclined at 54.7 degrees with respect to the surface of the silicon substrate 1 does not appear in the amorphous layer 6.

When annealing is performed in a non-oxidizing atmosphere, the dopants are activated and recrystallization of the amorphous layer 6 occurs. However, as the plane S_{1,1,1} corresponding to the [111 ] direction V₁,₁,₁ does not appear in the amorphous layer 6, epitaxial growth preferentially occurs in the [100] direction V₁,ₒ,ₒ, and a high-dose dopant diffusion layer 7 without crystal lattice defects is formed.

As described hereinbefore, according to the second embodiment, simply due to isotropic etching of the side walls 4 used as a mask material in high dose ion implantation, the inclination of the surface of the side walls with respect to the surface of the silicon substrate 1 does not exceed 54.7 degrees. Hence, without complicating the manufacturing procedure, the high-dose dopant diffusion layer 7 is formed free from crystal lattice defects when the amorphous layer 6 due to high dose ion implantation of dopants is recrystallized. This prevents deterioration of semiconductor characteristics, and prevents decline of yield.

### Third Embodiment

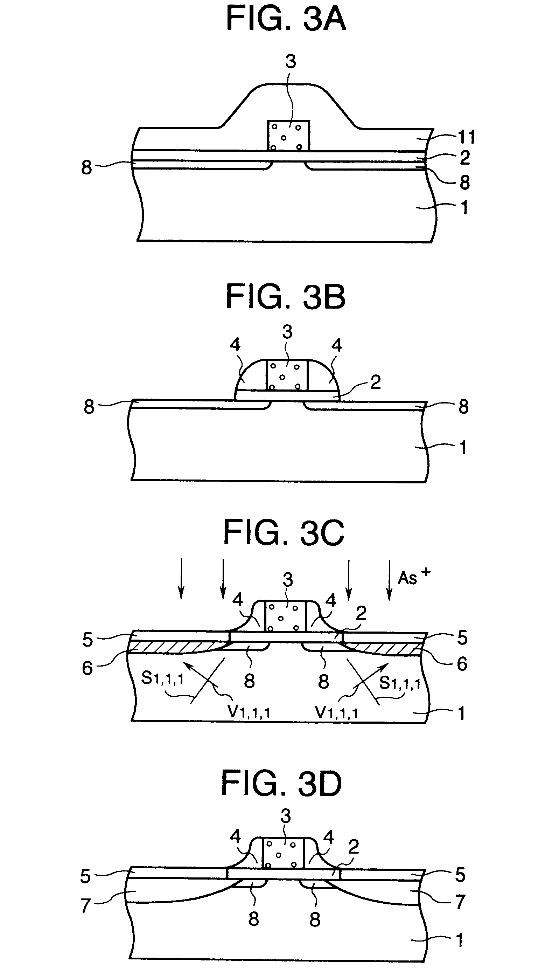

Figs. 3A-3D show the process of manufacturing a semiconductor device according to a third embodiment of this invention. This process will be described with reference to Figs. 3A-3D.

Gate oxidation is performed by thermal oxidation so as to form a gate oxide film 2 on a surface of a silicon substrate 1 in the same way as normally used to manufacture a MOSFET, and polysilicon to form a gate electrode 3 is deposited by CVD. After photolithography, anisotropic etching is performed so as to pattern the aforesaid polysilicon and form the gate electrode 3 shown in Fig. 3A. Using this gate electrode 3 as a mask, a dopant such as phosphorus is ion implanted at low dose (below 1 x 1014 [cm-9). Annealing is performed in a non-oxidizing atmosphere to form a low dose diffusion layer 8, and an insulating film 11 having a high fluidity, such as a silicon oxide film or the like, is thickly deposited over the whole surface.

The deposited insulating film 11 is then subjected to anisotropic etching so as to form side walls 4 as shown in Fig. 3B.

Next, annealing is performed at a temperature of from 850°C to 900°C in a dry or wet oxidizing atmosphere to form a silicon oxide film 5 of approximately 20 [nm] thickness on the silicon substrate 1. Athermal flow of the insulating film 11 (shown in Fig. 3A) forming the side walls 4 is set up, causing the lateral sloping faces of the side walls 4 to become gentle. The angle between the side walls 4 and the surface of the silicon substrate 1 then does not exceed 54.7 degrees, as shown in Fig. 3C. Subsequently, high dose ion implantation (above 1 x 10¹⁵ [cm-²]) of a dopant such as arsenic is performed. Due to the damage caused by ion implantation, an amorphous layer 6 is formed on the surface of the silicon substrate 1, but due to the shape of the side walls 4, a plane inclined at 54.7 degrees with respect to the surface of the silicon substrate 1 does not appear in the amorphous layer 6.

When annealing is performed in a non-oxidizing atmosphere, the dopants are activated and recrys- tall ization of the amorphous layer 6 occurs. However, as the plane S₁,₁,₁ corresponding to the [111] direction V₁,₁,₁ does not appear, epitaxial growth preferentially occurs in the [100] direction V₁,ₒ,ₒ, and a high-dose dopant d iffusion layer 7 without crystal lattice defects is formed.

As described hereinbefore, according to the third embodiment, the side walls 4 which function as a mask material in high dose ion implantation are formed by the normal method using a silicon oxide film or the like which has a high thermal fluidity, and thermal oxidation is then performed so that the inclination of the side walls with respect to the surface of the silicon substrate 1 does not exceed 54.7 degrees. A semiconductor can thus be easily manufactured, and scatter of semiconductor properties within the same wafer is reduced. Moreover, the high-dose dopant diffusion layer 7 is formed free from crystal lattice defects when the amorphous layer 6 due to high dose ion implantation of dopants is recrystallized. This prevents deterioration of semiconductor characteristics, and prevents decline of yield.

### Fourth Embodiment

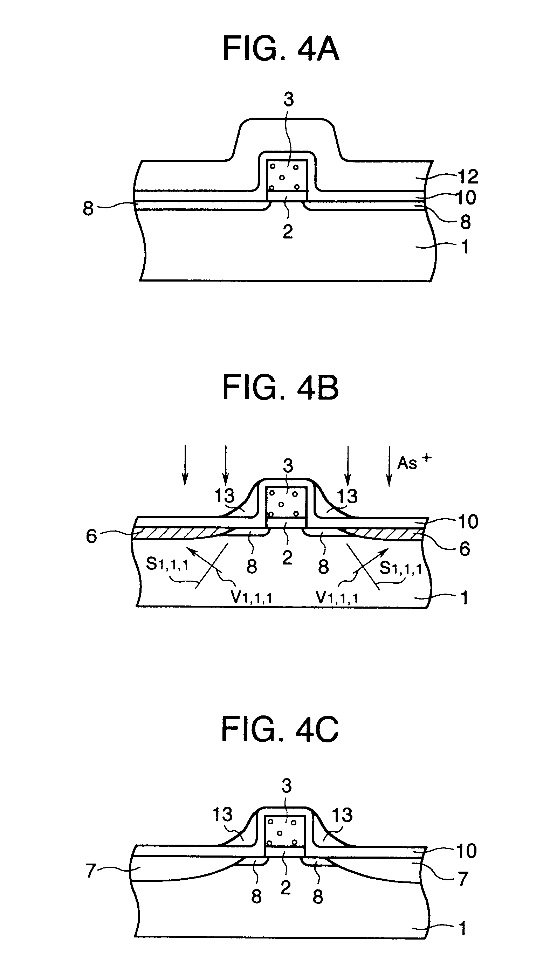

Figs. 4A-4C shows the process of manufacturing a semiconductor device according to a fourth embodiment of this invention. This process will be described with reference to Figs. 4A-4C.

Gate oxidation is performed by thermal oxidation so as to form a gate oxide film 2 on a surface of a silicon substrate 1 in the same way as normally used to manufacture a MOSFET, and polysilicon to form a gate electrode 3 is deposited by CVD. After photolithography, anisotropic etching is performed so as to pattern the aforesaid polysilicon and form the gate electrode 3 shown in Fig. 4A. Using this gate electrode 3 as a mask, a dopant such as phosphorus is ion implanted at low dose (below 1 x 1014 [cm-²]). Annealing is performed in a non-oxidizing atmosphere to form a low-dose dopant diffusion layer 8. An insulating film 10 having a high fluidity, such as NSG or the like, is deposited over the whole surface to a thickness of approximately 20 [nm] as a first insulating layer by means of CVD at normal pressure or reduced pressure. An insulating film 12 having a different etching rate from that of the insulating film 10, such as a silicon or silicon nitride film, is then thickly deposited over the whole surface.

The deposited insulating film 12 is then subjected to selective isotropic etching so as to form spacers 13 sloping gently on both sides of the gate electrode 3 as shown in Fig. 4B. These spacers 13 are formed such that the angle between surfaces of the spacers 13 and the surface of the silicon substrate 1 does not exceed 54.7 degrees. This can be achieved by adjusting for example the pressure of the etching gas or other etching materials. As two insulating films having a different etching rate are used, a wide process margin can be taken. Subsequently, high dose ion implantation (above 1 x 10¹⁵ [cm-9) of a dopant such as arsenic is performed. Due to the damage caused by ion implantation, an amorphous layer 6 is formed on the surface of the silicon substrate 1, but due to the shape of the spacers 13, a plane inclined at 54.7 degrees with respect to the surface of the silicon substrate 1 does not appear in the amorphous layer 6.

When annealing is performed in a non-oxidizing atmosphere, the dopants are activated and recrystallization of the amorphous layer 6 occurs. However, as the plane S_{1,1,1} corresponding to the [111 ] direction V₁,₁,₁ does not appear in the amorphous layer 6, epitaxial growth preferentially occurs in the [100] direction V₁,ₒ,ₒ, and a high-dose dopant diffusion layer 7 without crystal lattice defects can be formed as shown in Fig. 4C.

As described hereinbefore, according to the fourth embodiment, the insulating film 10, which is the first insulating film, is formed smoothly on the lateral faces of the gate electrode 3 using materials of high fluidity. Further, the inclination of the spacers 13, which function as a second insulating film having a different etching rate from that of the first insulating film 10, is arranged by isotropic etching on the lateral faces of the gate electrode 3 not to exceed 54.7 degrees. As the insulating film 10 and spacers 13 are used as a mask when high-dose dopant ion implantation is performed, a wide process margin can be taken. Moreover, the high-dose dopant diffusion layer 7 is formed free from crystal lattice defects when the amorphous layer 6 due to high dose ion implantation of dopants is recrystallized. This prevents deterioration of semiconductor characteristics, and prevents decline of yield.

### Fifth Embodiment

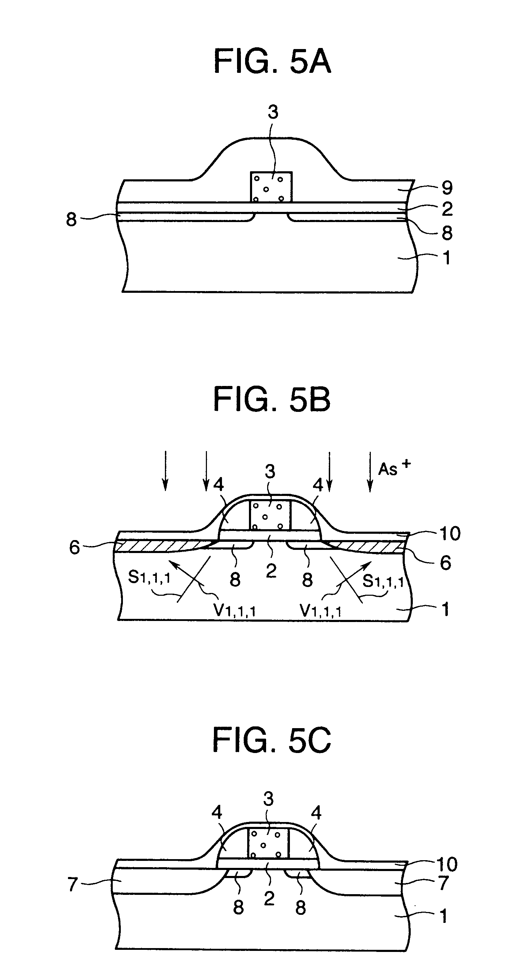

Figs. 5A-5C show the process of manufacturing a semiconductor device according to a fifth embodiment of this invention. This process will be described with reference to Figs. 5A-5C.

Gate oxidation is performed by thermal oxidation so as to form a gate oxide film 2 on a surface of a silicon substrate 1 in the same way as normally used to manufacture a MOSFET, and polysilicon to form a gate electrode 3 is deposited by CVD. After photolithography, anisotropic etching is performed so as to pattern the aforesaid polysilicon and form the gate electrode 3 shown in Fig. 5A. Using this gate electrode 3 as a mask, a dopant such as phosphorus is ion implanted at low dose (below 1 x 1014 [cm-9). Annealing is performed in a non-oxidizing atmosphere to form a low-dose dopant diffusion layer 8. An insulating film 9 such as a silicon oxide film or the like is then thickly deposited as a first insulating film over the whole surface.

The deposited insulating film 9 is subjected to anisotropic etching so as to form the ordinary side walls 4, and an insulating film 10 of NSG or the like which has a high fluidity, is deposited as a second insulating film over the whole surface to a thickness of approximately 20 [nm] by means of CVD at normal pressure or reduced pressure. Due to the fluidity of the insulating film 10, the edges of the insulating film 10 on the side walls 4 can be made smooth, and the angle between the edges of the side walls 4 and the surface of the silicon substrate 1 is arranged not to exceed 54.7 degrees. By controlling the film thickness of the insulating film 10, the shape of the side walls 4 can be precisely controlled. Subsequently, high dose ion implantation (above 1 x 10¹⁵ [cm-²]) of a dopant such as arsenic is performed. Due to the damage caused by ion implantation, an amorphous layer 6 is formed on the surface of the silicon substrate 1, but due to the shape of the side walls 4, a plane inclined at 54.7 degrees with respect to the surface of the silicon substrate 1 does not appear in the amorphous layer 6.

When annealing is performed in a non-oxidizing atmosphere, the dopants are activated and recrystallization of the amorphous layer 6 occurs. However, as the plane S₁,₁,₁ corresponding to the [111 ] direction V₁,₁,₁ does not appear in the amorphous layer 6, epitaxial growth preferentially occurs in the [100] direction V₁,ₒ,ₒ, and a high-dose dopant diffusion layer 7 without crystal lattice defects is formed as shown in Fig. 5C.

As described hereinbefore, according to the fifth embodiment, the side walls 4 which function as a mask during high-dose dopant implantation are formed by the ordinary method, the insulating film 10 is formed on the side walls 4 using a high fluidity material, and the inclination of the insulating film 10 with respect to the surface of the silicon substrate 1 is arranged not to exceed 54.7 degrees. By controlling the film thickness of the insulating film 10, the shape of the film can be precisely controlled. Moreover, the high-dose dopant diffusion layer 7 is formed free from crystal lattice defects when the amorphous layer 6 due to high dose ion implantation of dopants is recrystallized. This prevents deterioration of semiconductor characteristics, and prevents decline of yield.

### Sixth Embodiment

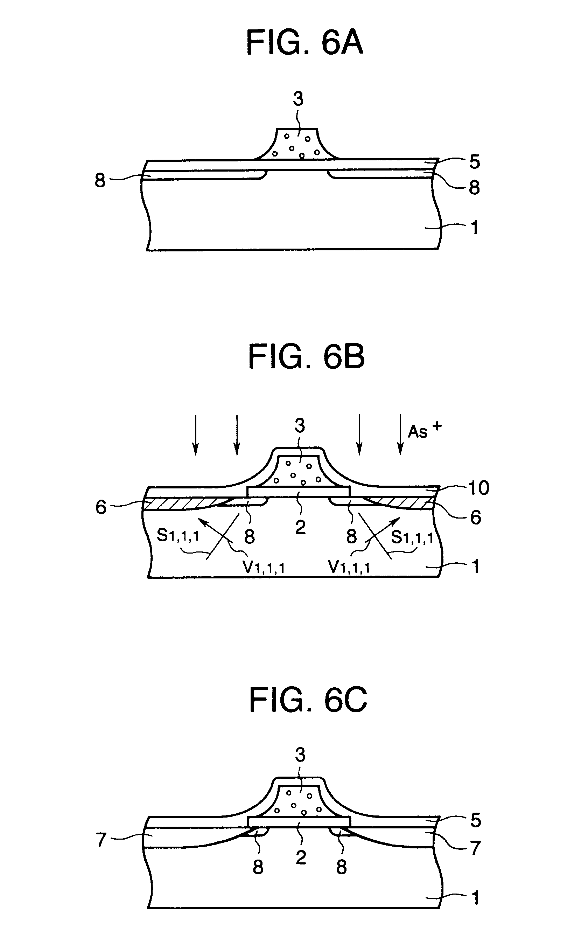

Figs. 6A-6C show the process of manufacturing a semiconductor device according to a sixth embodiment of this invention. This process will be described with reference to Figs. 6A-6C.

Gate oxidation is performed by thermal oxidation so as to form a gate oxide film 2 on a surface of a silicon substrate 1, and polysilicon to form a gate electrode 3 is deposited by CVD on the gate oxide film 2. After photolithography, isotropic etching is performed so as to pattern the aforesaid polysilicon and form the gate electrode 3 shown in Fig. 6A. Using this gate electrode 3 as a mask, a dopant such as phosphorus is ion implanted at low dose (below 1 x 1014 [cm⁻²]). Annealing is then performed in a non-oxidizing atmosphere to form a low dose diffusion layer 8.

The gate oxide film 2 is etched with fluoric acid or the like, and an insulating film 10 of NSG orthe like which has a high fluidity, is deposited as a second insulating film over the whole surface to a thickness of approximately 20 [nm] by means of CVD at normal pressure or reduced pressure, as shown in Fig. 6B. The side walls of the gate electrode 3 are smooth, and due to the high fluidity of the insulating film 10, the insulating film 10 is deposited smoothly on the side walls of the gate electrode 3. By controlling the film thickness of the insulating film 10, the shape of the film on the side walls of the gate electrode 3 can be precisely controlled, the width of the side walls can be made very small and scatter of semiconductor properties within the same wafer is reduced. Further, the angle between the film 10 on the side walls of the gate electrode 3 and the surface of the silicon substrate 1 is arranged not to exceed 54.7 degrees. Subsequently, high dose ion implantation (above 1 x 10¹⁵ [cm-²]) of a dopant such as arsenic is performed. Due to the damage caused by ion implantation, an amorphous layer 6 is formed on the surface of the silicon substrate 1, but due to the shape of the side walls 4, a plane inclined at 54.7 degrees with respect to the surface of the silicon substrate 1 does not appear in the amorphous layer 6.

When annealing is performed in a non-oxidizing atmosphere, the dopants are activated and recrys- tall ization of the amorphous layer 6 occurs. However, as the plane S₁,₁,₁ corresponding to the [111] direction V₁,₁,₁ does not appear in the amorphous layer 6, epitaxial growth preferentially occurs in the [100] direction V₁,ₒ,ₒ, and a high-dose dopant diffusion layer 7 without crystal lattice defects is formed as shown in Fig. 6C.

As described hereinbefore, according to the sixth embodiment, a smooth gate electrode 3 is formed by isotropic etching, a high fluidity insulating film 10 is formed on this gate electrode 3, and the inclination of the insulating film 10with respect to the surface of the silicon substrate 1 is arranged not to exceed 54.7 degrees. The shape of the film 10 can thus be precisely controlled, the width of the side walls can be made very small and scatter of semiconductor properties within the same wafer is reduced. Moreover, the high-dose dopant diffusion layer 7 is formed free from crystal lattice defects when the amorphous layer 6 due to high dose ion implantation of dopants is recrystallized. This prevents deterioration of semiconductor characteristics, and prevents decline of yield.

### Seventh Embodiment

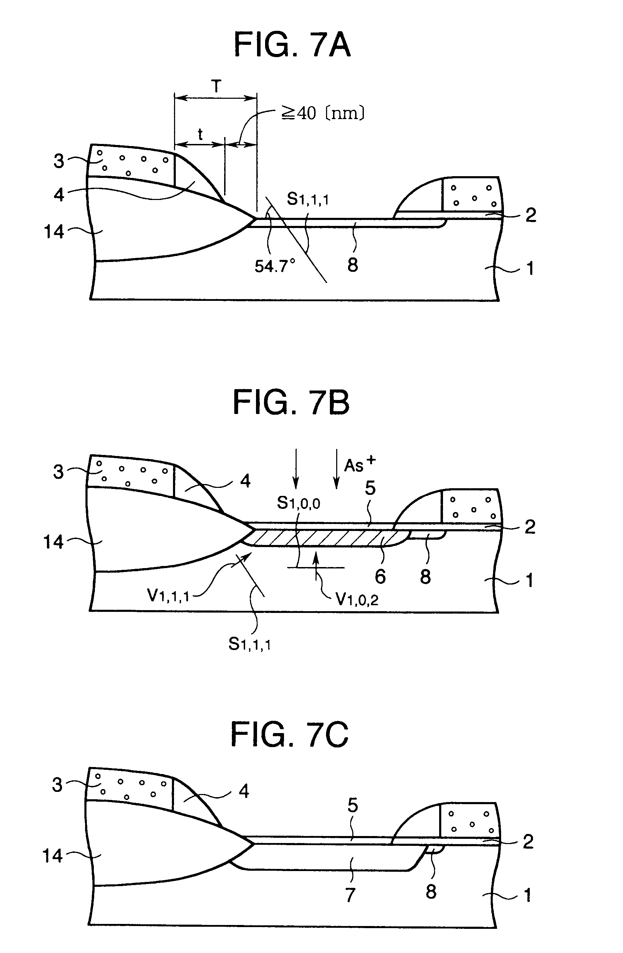

Figs. 7A-7C show a process of manufacturing a semiconductor device according to a seventh embodiment of this invention. This process will now be described with reference to left-hand parts of Figs. 7A-7C.

As shown in Fig. 7A, the field oxide film 14 with bird's beak and the low dose diffusion layer 8 are formed on a surface of a silicon substrate 1. The bird' beak of the field oxide film 14 does not have a plane inclined at an angle of 54.7 degrees of more with respect to the surface of the silicon substrate 1. The gate electrode 3 and side wall 4 are formed on the field oxide film 14 such that the distance T from the edge of the gate electrode 3 to the edge of the film 14 is greater than the width t of the side wall 4 (more preferably, (T - t) is not less than 40 [nm]), and so that the side walls 4 is far from and do not cover the active region of the device.

After forming a silicon oxide film 5 of thickness approximately 20 [nm] by thermal oxidation, high dose ion implantation (above 1 x 10¹⁵ [cm-²]) of a dopant such as arsenic is performed. Due to the damage caused by ion implantation, an amorphous layer 6 is formed on the surface of the silicon substrate 1 as shown in Fig. 7B, the field oxide film 14 acting as a mask. However, as the distance T from the edge of the gate electrode 3 to the edge of the field oxide film 14, is related to the width t of the side walls by the relation that (T - t) is not less than 40 [nm], due to the shape of the edges of the field oxide film 14, a plane inclined at 54.7 degrees with respect to the surface of the silicon substrate 1 does not appear in the amorphous layer 6.

When annealing is performed in a non-oxidizing atmosphere, the dopants are activated and recrystallization of the amorphous layer 6 occurs. However, as the plane S₁,₁,₁ corresponding to the [111 ] direction V₁,₁,₁ does not appear in the amorphous layer 6, epitaxial growth preferentially occurs in the [100] direction and a high-dose dopant diffusion layer 7 without crystal lattice defects is formed as shown in Fig. 7C. Further, as there are no crystal lattice defects in the subsequent heat treatment, dislocations and lamination defects in the field oxide film 14 are avoided.

As described hereinbefore, according to the seventh embodiment, the distance Tfrom the edge of the gate electrode 3 to the edge of the film 14 satisfies the relation T > t (preferably, (T - t) is not less than 40 [nm]) so that the side wall 4 is far from and does not cover the active region of the device. The high-dose dopant diffusion layer 7 is therefore formed free from crystal lattice defects when the amorphous layer 6 due to high dose ion implantation of dopants is recrystallized. This prevents deterioration of semiconductor characteristics, and prevents decline of yield.

### Eighth Embodiment

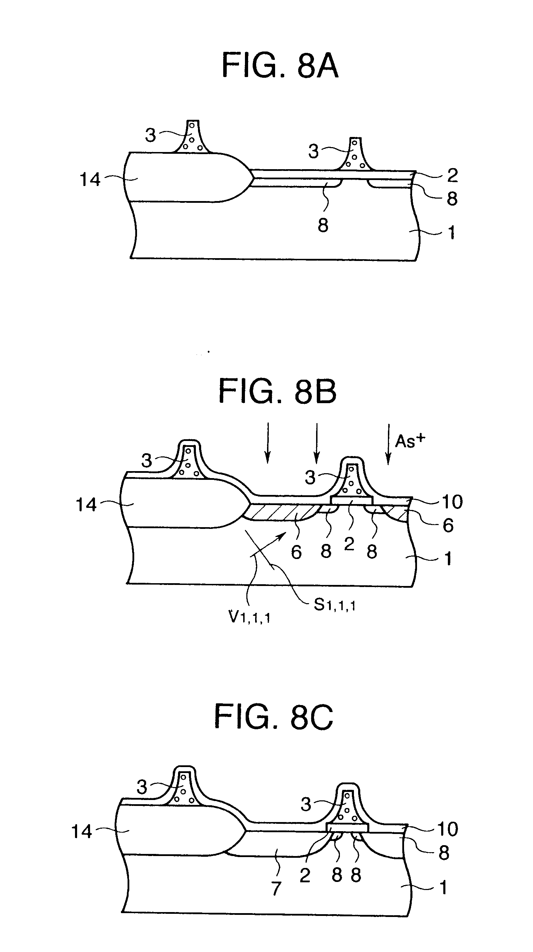

Figs. 8A-8C show a process of manufacturing a semiconductor device according to an eighth embodiment of this invention. This process will now be described with reference to Figs. 8A-8C.

A field oxide film 14 of approximately 400 [nm] thickness is formed on a surface of a silicon substrate 1 by LOCOS method, which including the processes of forming a pad oxide film of approximately 20 [nm] thickness by thermal oxidation, forming a mask nitride film of approximately 150 [nm] thickness on the pad oxide film, patterning the mask nitride film, and producing a field oxide film 14 by thermal oxidation (at 1000°C and wet atmosphere). The edge of the field oxide film 14 become a smooth bird's beak, and the angle between the bird's beak and the surface of the silicon substrate 1 not exceeding 54.7 degrees. Gate oxidation performed by thermal oxidation so as to form a gate oxide film 2 on the silicon substrate 1, and polysilicon to form a gate electrode 3 is deposited by CVD on the gate oxide film 2. After photolithography, isotropic etching performed so as to pattern the aforesaid polysilicon. The gate electrode 3 then assumes a tapered shape, as shown in Fig. 8A. Using this gate electrode 3 as a mask, a dopant such as phosphorus is ion implanted at low dose (below 1 x 10¹⁴ [cm-²]). Annealing is then performed in a non-oxidizing atmosphere to form a low-dose dopant diffusion layer 8.

The gate oxide film 2 is etched with fluoric acid orthe like, and an insulating film 10of NSGorthe like which has a high fluidity, is deposited as a second insulating film over the entire surface to a thickness of approximately 20 [nm] by means of CVD at normal pressure or reduced pressure. The gate electrode 3 has a tapered shape, and due to the high fluidity of the insulating film 10, the insulating film 10 is deposited smoothly as shown in Fig. 8B. The angle made by the insulating film 10 on the side walls of the gate electrode 3 and the bird's beak of the field oxide film 14 with respect to the surface of the silicon substrate 1 does not exceed 54.7 degrees. In this structure, the function of side walls is fulfilled by the insulating film 10. Subsequently, high dose implantation (above 1 x 10¹⁵ [cm-9) of a dopant such as arsenic is performed. Due to the damage caused by ion implantation, an amorphous layer 6 is formed on the surface of the silicon substrate 1, but due to the shape of the insulating film 10 which functions as side walls, a plane inclined at 54.7 degrees with respect to the surface of the silicon substrate 1 does not appear in the amorphous layer 6.

When annealing is performed in a non-oxidizing atmosphere, the dopants are activated and recrys- tall ization of the amorphous layer 6 occurs. However, as the plane S₁,₁,₁ corresponding to the [111] direction V₁,₁,₁ does not appear in the amorphous layer 6, epitaxial growth preferentially occurs in the [100] direction V₁,ₒ,ₒ, and a high-dose dopant diffusion layer 7 without crystal lattice defects is formed as shown in Fig. 8C.

As described hereinbefore, according to the eighth embodiment, a smooth gate electrode 3 is formed by isotropic etching, a high fluidity insulating film 10 is formed on this gate electrode 3, and it is arranged that the inclination of the insulating film 10 with respect to the surface of the silicon substrate 1 does not exceed 54.7 degrees. The shape of the film 10 can thus be precisely controlled, and as the insulating film 10 and field oxide film 14 are used as mask materials in high dose ion implantation, a high-dose dopant diffusion layer 7 is formed free from crystal lattice defects when the amorphous layer 6 due to high dose ion implantation of dopants is recrystallized. This prevents deterioration of semiconductor characteristics, and prevents decline of yield.

### Ninth Embodiment

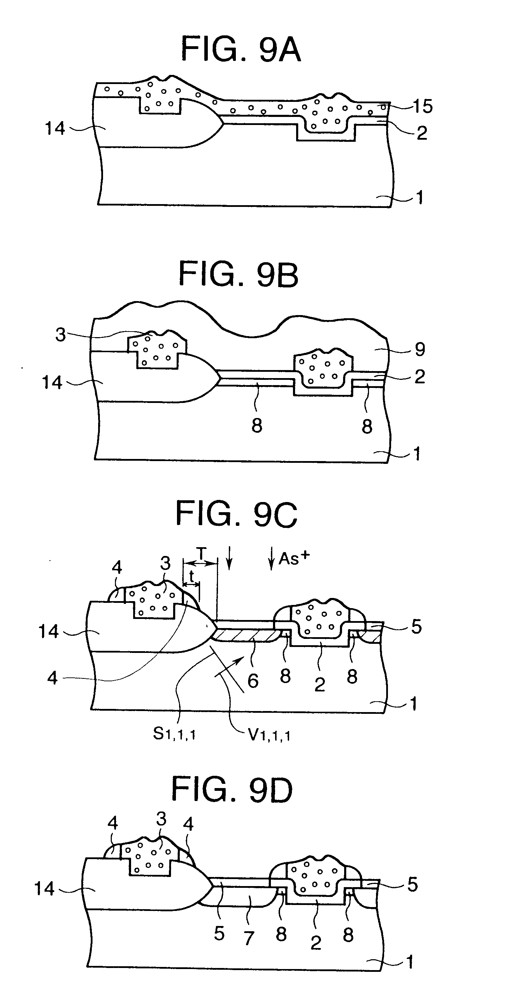

Figs. 9A-9C show a process of manufacturing a semiconductor device according to a ninth embodiment of this invention. This process will now be described with reference to the left-hand side of Figs. 9A-9C.

A field oxide film 14 is formed by the LOCOS method. The edge of the field oxide film 14 become a smooth bird's beak, and the angle between the bird's beak and the surface of the silicon substrate 1 not exceeding 54.7 degrees.

A resist pattern is formed by photolithography in regions other than that occupied by a gate electrode 3, anisotropic etching is performed using this resist pattern as a mask, and a groove of approximately 150 [nm] depth is formed in the field oxide film 14. As shown in Fig. 9A, after performing gate oxidation so as to form a gate oxide film 2, polysilicon 15 is deposited by CVD to a film thickness of approximately 200 [nm] on the gate oxide film 2 and the field oxide film 14.

After photolithography, the polysilicon 15 is patterned by anisotropic etching, and the gate electrode 3 is formed as shown in Fig. 9B. Using this gate electrode 3 as a mask, low dose ion implantation (below 1 x 1014 [cm⁻²]) is performed using for example phosphorus, and annealing is carried out in a non-oxidizing atmosphere so as to form a low dose diffusion layer 8. An insulating film 9, for example a silicon oxide film, is then thickly formed.

The side walls 4 are formed by etching back the deposited insulating film 9. In this process, the gate electrode 3 is embedded in the groove, hence the effective height of the gate electrode 3 is low, and the width of the side walls 4 can be made small. It is thus possible to set the condition that (T - t) is not less than 40 [nm], where T is the distance from the edge of the gate electrode 3 on the insulating film 14 to the edge of the film 14, and t is the width of the side wall 4, as shown in Fig. 9C. Subsequently, high dose implantation (above 1 x 10¹⁵ [cm-²]) of a dopant such as arsenic is performed. Due to the damage caused by ion implantation, an amorphous layer 6 is formed on the surface of the silicon substrate 1, but due to the shape of the side walls 4 and the shape of the bird's beak of the insulating film 14, a plane inclined at 54.7 degrees with respect to the surface of the silicon substrate 1 does not appear in the amorphous layer 6.

When annealing is performed in a non-oxidizing atmosphere, the dopants are activated and recrystallization of the amorphous layer 6 occurs. However, as the plane S_{1,1,1} corresponding to the [111 ] direction V₁,₁,₁ does not appear in the amorphous layer 6, epitaxial growth preferentially occurs in the [100] direction, and a high-dose dopant diffusion layer 7 without crystal lattice defects is formed as shown in Fig. 9D.

As described hereinbefore, according to the ninth embodiment, there is only a small step due to the gate electrode 3 as the gate electrode 3 on the field oxide film 14 is of the embedded type. The side wall 4 on the wall of the gate electrode 3 therefore is far from and does not cover the active region, and a high-dose dopant diffusion layer 7 is formed free from crystal lattice defects when the amorphous layer 6 due to high dose ion implantation of dopants is recrystallized. This prevents deterioration of semiconductor characteristics, and prevents decline of yield.

### Tenth Embodiment

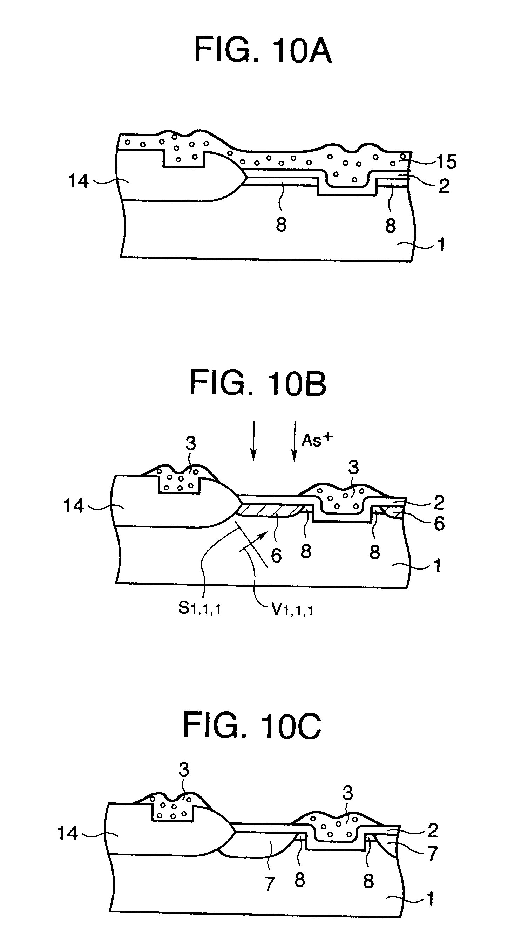

Figs. 10A-10C show a process of manufacturing a semiconductor device according to a tenth embodiment of this invention. This process will now be described with reference to Figs. 10A-10C.

As shown in Fig. 10A, a field oxide film 14 is formed by the LOCOS method. The edge of the field oxide film 14 become a smooth bird's beak, and the angle between the bird's beak and the surface of the silicon substrate 1 not exceeding 54.7 degrees.

Low dose ion implantation is performed, using a dopant such as phosphorus, so as to form a low-dose dopant diffusion layer 8. A resist pattern is formed by photolithography in regions other than that occupied by a gate electrode 3, anisotropic etching is performed using this resist pattern as a mask, and a groove of approximately 150 [nm] depth is formed in the field oxide film 14 and the silicon substrate 1. After performing gate oxidation so as to form a gate oxide film 2, polysilicon 15 is deposited by CVD to a film thickness of approximately 200 [nm] on the gate oxide film 2 and the field oxide film 14.

An etch back process is performed on the polysilicon 15 so as to form a embedded gate electrode 3, as shown in Fig. 10B. Subsequently, high dose implantation (above 1 x 10¹⁵ [cm-9) of a dopant such as phosphorus is performed. Due to the damage caused by ion implantation, an amorphous layer 6 is formed on the surface of the silicon substrate 1, but due to the shape of side walls 4 and the shape of bird's beak of the insulating film 14, a plane inclined at 54.7 degrees with respect to the surface of the silicon substrate 1 does not appear in the amorphous layer 6.

When annealing is performed in a non-oxidizing atmosphere, the dopants are activated and recrys- tall ization of the amorphous layer 6 occurs. However, as the plane S₁,₁,₁ corresponding to the [111] direction V₁,₁,₁ does not appear in the amorphous layer 6, epitaxial growth preferentially occurs in the [100] direction, and a high-dose dopant diffusion layer 7 without crystal lattice defects is formed as shown in Fig. 10B.

As described hereinbefore, according to the tenth embodiment, the gate electrode 3 on the field oxide film 14 is of the embedded type. It may thus be specified that the gate electrode 3 on the field oxide film 14 is far from and does not cover the active region, and the process of forming side walls on the lateral walls of the gate electrode 3 may be omitted. Moreover, a high-dose dopant diffusion layer 7 is formed free from crystal lattice defects when the amorphous layer 6 due to high dose ion implantation of dopants is recrystallized. This prevents deterioration of semiconductor characteristics, and prevents decline of yield.

### Eleventh Embodiment

A high-dose dopant diffusion layer free of crystal defects may be manufactured also with an ordinary side wall shape by the different dopant implantation method.

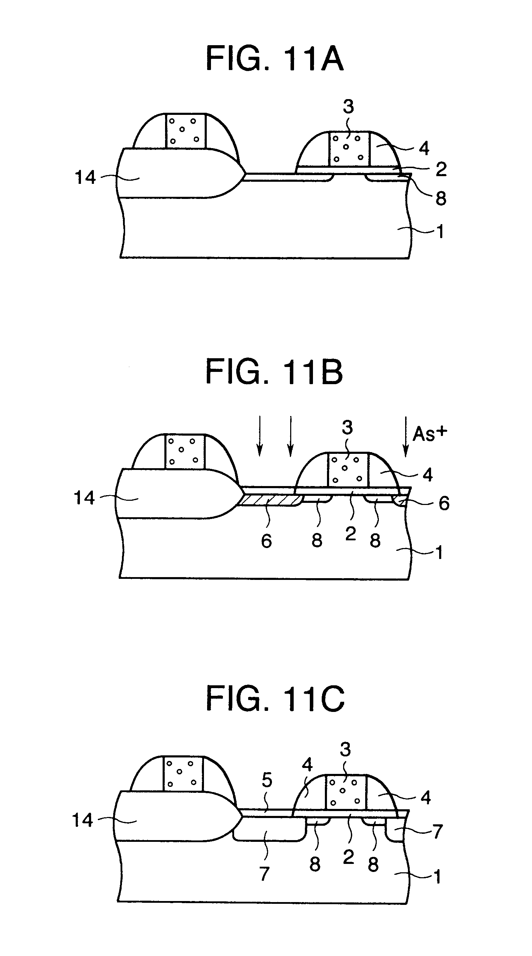

Figs. 11A-11C show a process of manufacturing a semiconductor device according to an eleventh embodiment of this invention. This process will now be described with reference to Figs 11A-11C.

A field oxide film 14 is formed by the LOCOS method, as shown in Fig. 11A. A gate electrode film 2 is then formed by gate oxidation, and polysilicon to form a gate electrode 3 is deposited on the gate oxide film 2. After photolithography, the polysilicon is patterned by anisotropic etching. Using this gate electrode 3 as a mask, low dose ion implantation (below 1 x 10¹⁴ [CM-9) of for example phosphorus is performed, and annealing is carried out in a non-oxidizing atmosphere so as to form a low-dose dopant diffusion layer 8. An insulating film such as a silicon oxide film is then thickly deposited, and this film is subjected to anisotropic etching so as to form ordinary side walls 4.

After forming a silicon oxide film 5 of approximately 20 [nm] on the surface of the silicon substrate 1 by thermal oxidation, implantation (not more than 1 x 10¹⁵ [cm-²]) of a dopant such as arsenic is performed. The critical dose at which crystal lattice defects occur when the amorphous layer is recrystallized is approximately 1 x 10¹⁵ [cm-²] in the case of arsenic and approximately 4 x 10¹⁵ [cm-²] in the case of phosphorus, so the dosage of dopants is maintained below these critical doses. The dopants are then diffused in the silicon substrate 1 and an amorphous layer 6 formed by ion implantation is recrystallized by annealing in a non-oxidizing atmosphere. As the dosage of dopants does not exceed the critical levels, crystal lattice defects do not occur.

By repeating the ion implantation and annealing processes several times, a high-dose dopant diffusion layer 7 free of crystal lattice defects is formed as shown in Fig. 11C.

As described hereinbefore, according to the eleventh embodiment, ion implantation of dopants is repeatedly performed at dosage levels below the critical doses at which crystal defects occur in the amorphous layer formed by high dose ion implantation. A high-dose dopant diffusion layer 7 free of crystal lattice defects is thereby obtained. This prevents deterioration of semiconductor properties and decline of yield.

### Twelfth Embodiment

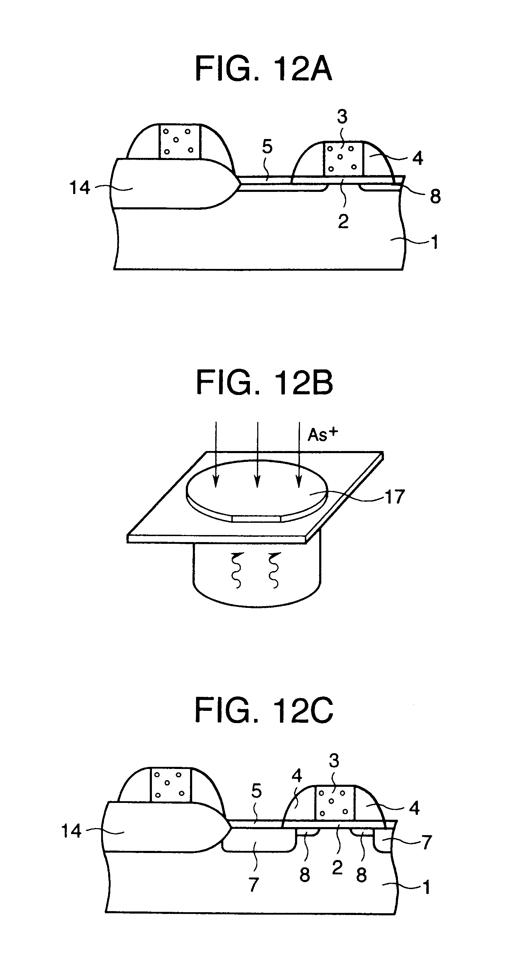

Figs. 12A-12C show a process of manufacturing a semiconductor device according to a twelfth embodiment of this invention. This process will now be described with reference to Figs. 12A-12C.

A field oxide film 14 is formed by the LOCOS method, as shown in Fig. 12A. A gate electrode film 2 is then formed by gate oxidation, and polysilicon to form a gate electrode 3 is deposited on the gate oxide film 2 by CVD. After photolithography, the polysilicon is patterned by anisotropic etching. Using this gate electrode 3 as a mask, low dose ion implantation (below 1 x 1014 [cm-²]) of for example phosphorus is performed, and annealing is carried out in a non-oxidizing atmosphere so as to form a low-dose dopant diffusion layer 8. An insulating film such as a silicon oxide film is then thickly deposited, this film is subjected to anisotropic etching so as to form ordinary side walls 4, and a silicon oxide film 5 of approximately 20 [nm] is formed on the surface of the silicon substrate 1 by thermal oxidation.

Awafer 17 is applied to the lamp annealing or the like as shown in Fig. 12B so as to maintain the wafer 17 at a high level of approximately 300°C - 400°C, and ion implantation of a dopant such as arsenic is performed at high dose (above 1 x 10¹⁵ [cm-²]). As the wafer 17 is maintained at a high temperature, the damage caused by ion implantation is repaired during the process, and an amorphous layer is not formed in the silicon substrate 1. Further, at a temperature of approximately 300°C - 400°C, there is effectively no diffusion of dopants implanted in the silicon substrate 1.

A high dose diffusion layer 7 is then formed, as shown in Fig. 12C, by annealing in a non-oxidizing atmosphere. According to this manufacturing process, an amorphous layer is not formed in the silicon substrate 1, hence a high-dose dopant diffusion layer 7 free of crystal lattice defects can be obtained.

As described hereinbefore, according to the twelfth embodiment, ion implantation of dopants is performed while the temperature is maintained at a high level of approximately 300°C - 400°C by lamp annealing or a similar process applied to the wafer 17. Hence, damage is repaired during the process, the amorphous layer is not formed, and a high-dose dopant diffusion layer 7 free of crystal lattice defects is obtained. This prevents deterioration of semiconductor properties and decline of yield.

### Thirteenth Embodiment

Figs. 13A-13C show a process of manufacturing a semiconductor device according to a thirteenth embodiment of this invention. This process will now be described with reference to Figs. 13A-13C.

A field oxide film 14 is formed by the LOCOS method, as shown in Fig. 13A. A gate electrode film 2 is then formed by gate oxidation, and polysilicon to form a gate electrode 3 is deposited on the gate oxide film 2. After photolithography, the polysilicon is patterned by anisotropic etching. Using this gate electrode 3 as a mask, low dose ion implantation (below 1 x 10¹⁴ [cm⁻²]) of for example phosphorus is performed, and annealing is carried out in a non-oxidizing atmosphere so as to form a low-dose dopant diffusion layer 8. An insulating film such as a silicon oxide film is then thickly deposited, and this film is subjected to anisotropic etching so as to form ordinary side walls 4.

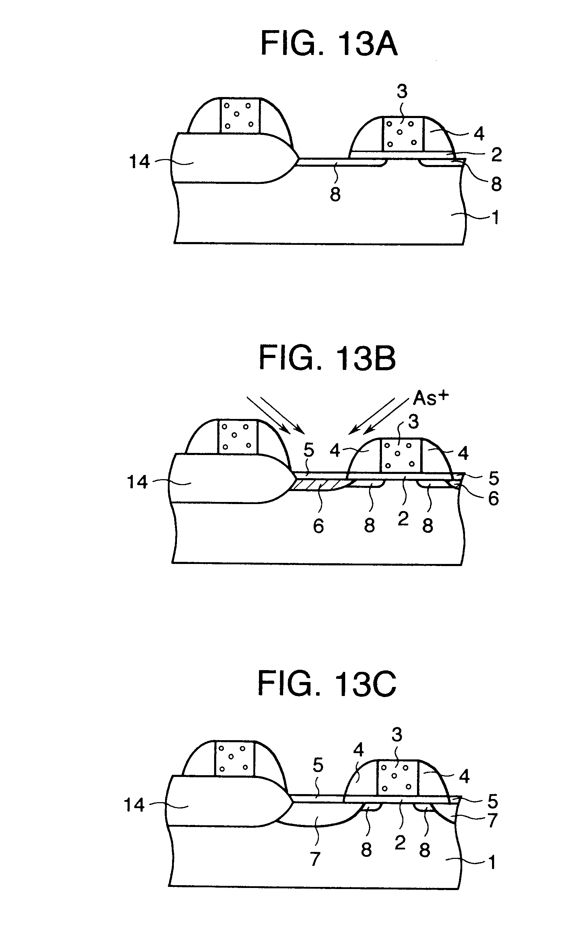

After forming a silicon oxide film 5 of approximately 20 [nm] on the surface of the silicon substrate 1 by thermal oxidation, ion implantation in the silicon substrate 1 of a dopant such as arsenic is performed at an oblique angle and at high dose (above 1 x 10¹⁵ [cm-²]). Due to the damage caused by ion implantation, an amorphous layer 6 is formed in the silicon substrate 1, however the angle of ion implantation is adjusted such that the angle made by the interface of the amorphous layer 6 with the silicon crystals does not exceed 54.7 degrees with respect to the surface of the silicon substrate 1, as shown in Fig. 13B.

A high-dose dopant diffusion layer 7 is then formed by annealing in a non-oxidizing atmosphere. As according to this manufacturing process, a plane S₁,₁,₁ corresponding to the [111] direction V₁,₁,₁ is not formed at the interface between the amorphous layer 6 and the silicon crystals, a high-dose dopant diffusion layer 7 free of crystal lattice defects is formed as shown in Fig. 13C.

As described hereinbefore, according to the thirteenth embodiment, when dopants are ion implanted at high dose at an oblique angle, the angle of ion implantation is adjusted such that the angle made by the interface between the amorphous layer 6 and the silicon crystals does not exceed 54.7 degrees with respect to the surface of the silicon substrate 1. A high-dose dopant diffusion layer 7 free of crystal lattice defects is therefore obtained. This prevents deterioration of semiconductor properties and decline of yield.

### Fourteenth Embodiment

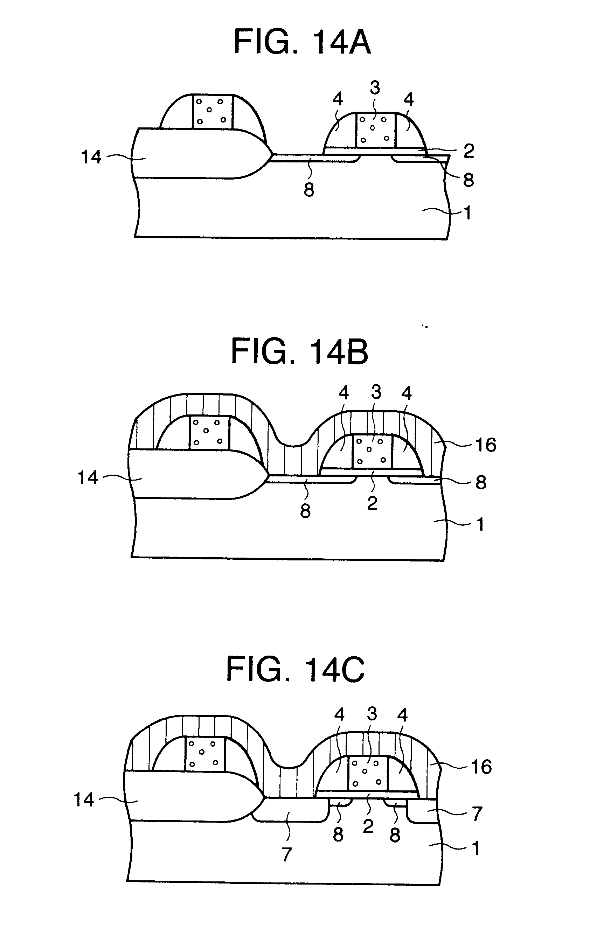

Figs. 14A-14C show a process of manufacturing a semiconductor device according to a fourteenth embodiment of this invention. This process will now be described with reference to Figs 14A-14C.

A field oxide film 14 is formed by the LOCOS method, as shown in Fig. 14A. A gate electrode film 2 is then formed by gate oxidation, and polysilicon to form a gate electrode 3 is deposited on the gate oxide film 2. After photolithography, the polysilicon is patterned by anisotropic etching. Using this gate electrode 3 as a mask, low dose ion implantation (below 1 x 10¹⁴ [CM-9) of for example phosphorus is performed, and annealing is carried out in a non-oxidizing atmosphere so as to form a low-dose dopant diffusion layer 8. An insulating film such as a silicon oxide film is then thickly deposited, and this film is subjected to anisotropic etching so as to form ordinary side walls 4.

After completely eliminating the silicon oxide film on the surface of the silicon substrate 1 in the active region, an insulating film 16, for example a silicon oxide film doped with a dopant such as arsenic at high dose (above 1 x 10¹⁵ [cm-9), is deposited over the entire surface as shown in Fig. 14B. This insulating film 16 may be formed for example by adding a dopant such as arsenic in a source gas by CVD at normal pressure or reduced pressure.

A high-dose dopant diffusion layer 7, as shown in Fig. 14C, is then formed by solid phase diffusion of dopants in the silicon substrate 1 by means of annealing in a non-oxidizing atmosphere at a temperature of approximately 800°C. As according to this manufacturing process, an amorphous layer is not formed in the silicon substrate 1, a high-dose dopant diffusion layer 7 free of crystal lattice defects can be obtained.

As described hereinbefore, according to the fourteenth embodiment, dopants are made to undergo solid phase diffusion in the silicon substrate 1 by annealing so as to form the high-dose dopant diffusion layer 7. A high-dose dopant diffusion layer 7 free of crystal lattice defects is therefore obtained. This prevents deterioration of semiconductor properties and decline of yield.

This invention is not limited to the aforesaid first to fourteenth embodiments, various modifications being possible within the scope and spirit of the invention. Specific examples of these modifications are as follows.

Firstly, the silicon substrate is not necessarily a (100) substrate, but the surface of the silicon substrate 1 may be slightly inclined with respect to the (100) plane.

Secondly, the shape of the edges of the surface of the amorphous layer 6, which is the ion implantation layer formed by high dose ion implantation of dopants, is not necessarily limited to that of the aforesaid first to tenth embodiments provided that the inclination of the edges with respect to a plane corresponding to the [100] crystal direction of silicon does not exceed 54.7 degrees.

## Claims

1. A method of fabricating a semiconductor device, comprising the steps of:
forming a mask layer on a surface of a silicon substrate so that an inclination angle of a surface of said mask layer with respect to the surface of said silicon substrate does not exceed 54.7 degrees;
implanting dopants at a high dose in said silicon substrate using said mask layer so that the surface of said silicon substrate is transformed into an amorphous layer, said amorphous layer having no inclination angle exceeding 54.7 degrees with respect to the surface of said silicon substrate; and
annealing said silicon substrate having said amorphous layer so that said amorphous layer grows into a high-dose dopant diffusion layer.

2. A method of claim 1, wherein the surface of said silicon substrate is (100) plane.

3. A method of claim 1, wherein said high dose at said implanting step is above 1 x 10¹⁵ [cm-²].

4. A method of claim 1, wherein said step of forming said mask layer comprising the steps of:
forming a gate electrode on the surface of said silicon substrate;
depositing a silicon oxide film over said gate electrode and the surface of said silicon substrate; and
etching said silicon oxide film by anisotropic etching process so that a side wall made from said silicon oxide remains only at a side of said gate electrode, thereby causing an inclination angle of a sloping face of said side wall with respect to the surface of said silicon substrate to be 54.7 degrees or less.

5. A method of claim 1, wherein said step of forming said mask layer comprising the steps of:
forming a gate electrode on the surface of said silicon substrate;
depositing a silicon oxide film having a high fluidity at a high temperature over said gate electrode and the surface of said silicon substrate;
etching said silicon oxide film by anisotropic etching process so that a side wall made from said silicon oxide remains only at a side of said gate electrode; and
annealing said side wall at a temperature between 850°C and 900°C in a dry or wet oxidizing atmosphere so as to flow said side wall, thereby causing an inclination angle of a sloping face of said side wall with respect to the surface of said silicon substrate to be 54.7 degrees or less.

6. A method of claim 1, wherein said step of forming said mask layer comprising the steps of:
forming a gate electrode on the surface of said silicon substrate;
depositing a first insulating layer having a high fluidity at a high temperature over said gate electrode and the surface of said silicon substrate;
depositing a second insulating layer having a different etching rate from that of said first insulating layer over said first insulating layer; and
etching said second insulating layer by anisotropic etching process so that a side wall made from said second insulating layers remains only at a side of said gate electrode covered by said first insulating layer, thereby causing an inclination angle of a sloping face of said side wall with respect to the surface of said silicon substrate to be 54.7 degrees or less.

7. A method of claim 1, wherein said step of forming said mask layer comprising the steps of:
forming a gate electrode on the surface of the silicon substrate;
depositing a first insulating layer over said gate electrode and the surface of said silicon substrate;
etching said first insulating layer by anisotropic etching process so that said first insulating layer remains only at a side of said gate electrode; and
depositing a second insulating layer having a high fluidity over said first insulating layer, said gate electrode and the surface of said silicon substrate, thereby causing an inclination angle of a sloping face of said second insulating layerwith respect to the surface of said silicon substrate to be 54.7 degrees or less.

8. A method of claim 1, wherein said step of forming said mask layer comprising the steps of:
forming said gate electrode having a gently sloping face on the surface of said silicon substrate; and
depositing an insulating layer having a high fluidity over said gate electrode and the surface of said silicon substrate, thereby causing an inclination angle of a sloping face of said insulating layer with respect to the surface of said silicon substrate to be 54.7 degrees or less.

9. A method of claim 1, wherein said step of forming said mask layer comprising the steps of:
forming a field oxide film having a bird's beak on a surface of said silicon substrate, said bird's beak having no plane inclined at an angle of more than 54.7 degrees with respect to the surface of said silicon substrate.

10. A method of claim 9, further comprising the steps of:
forming a gate electrode on said field oxide film;
depositing an insulating layer over said gate electrode and said field oxide film; and
etching said insulating layer by anisotropic etching process so that side wall made from said insulating layer remains only at a side of said gate electrode and (T - t) is not less than 40 [nm], where T is a distance from an edge of said gate electrode to an edge of said bird's beak and t is a width of said side wall;
said steps of implanting dopants and annealing said silicon substrate having said amorphous layer being performed after said etching step.

11. A method of claim 9, further comprising the steps of:
forming a gate electrode said field oxide film;
etching said gate electrode by anisotropic etching process so that said gate electrode has a tapered surface; and
depositing a thin insulating layer having a high fluidity over said gate electrode, said field oxide film and the surface of said silicon substrate;
said steps of implanting dopants and annealing said silicon substrate having said amorphous layer being performed after said depositing step.

12. A method of claim 9, further comprising the steps of:
forming a groove in said field oxide film;
forming a gate electrode in said groove of said field oxide film;
depositing an insulating layer over said gate electrode and said field oxide film; and
etching said insulating layer by anisotropic etching process so that side wall made from said insulating layer remains only at a side of said gate electrode and (T - t) is not less than 40 [nm], where T is a distance from an edge of said gate electrode to an edge of said bird's beak and t is a width of said side wall;
said steps of implanting dopants and annealing said silicon substrate having said amorphous layer being performed after said etching step.

13. A method of claim 9, further comprising the steps of:
forming a groove in said field oxide film;
forming a gate electrode over said field oxide film and said silicon substrate; and
etching said gate electrode by anisotropic etching process so that said gate electrode remains over said groove and has a tapered surface;
said steps of implanting dopants and annealing said silicon substrate having said amorphous layer being performed after said depositing step.

14. A method of fabricating a semiconductor device, comprising the steps of:
forming a mask layer on a surface of a silicon substrate;
forming a silicon oxide film on the surface of said silicon substrate 1 by thermal oxidation;
implanting dopants at a dose of not more than 1 x 10¹⁵ [cm-²] so that the surface of said silicon substrate is transformed into an amorphous layer; and
annealing said silicon substrate having said amorphous layer so that said amorphous layer grows into a high-dose dopant diffusion layer.

15. A method of fabricating a semiconductor device, comprising the steps of:
forming a mask layer on a surface of a silicon substrate;
forming a silicon oxide film on the surface of said silicon substrate 1 by thermal oxidation;
heating said silicon substrate at a temperature of 300°C - 400°C, and then implanting dopants at a high dose so that the surface of said silicon substrate is transformed into an amorphous layer; and
annealing said silicon substrate having said amorphous layer so that said amorphous layer grows into a high-dose dopant diffusion layer.

16. A method of fabricating a semiconductor device, comprising the steps of:
forming a mask layer on a surface of a silicon substrate;
forming a silicon oxide film on the surface of said silicon substrate 1 by thermal oxidation;
implanting dopants obliquely at a high dose so that the surface of said silicon substrate is transformed into an amorphous layer, said amorphous layer having no inclination angle exceeding 54.7 degrees with respect to the surface of said silicon substrate; and
annealing said silicon substrate having said amorphous layer so that said amorphous layer grows into a high-dose dopant diffusion layer.

17. A method of fabricating a semiconductor device, comprising the steps of:
forming a mask layer on a surface of a silicon substrate;
implanting dopants at a low dose below 1 x 10-¹⁴ [cm⁻²];
annealing said silicon substrate in non-oxidation atmosphere, thereby making a low-dose dopant diffusion layer;
forming side wall at a side of said gate electrode;
depositing an insulating layer including a dopant at a high dose above 1 x 10-¹⁵ [cm-²];
annealing said silicon substrate and said insulating layer at a temperature of about 800°C so that said dopant of said insulating layer diffuse into said silicon substrate and said low-dose dopant diffusion layer grows into a high-dose dopant diffusion layer.
